# FASCICULE DE BREVET EUROPEEN

(11) **EP 3 081 063 B1**
(45) Date de publication et mention de la délivrance du brevet: **04.03.2020**
(21) Numéro de dépôt: 14806618.6
(22) Date de dépôt: 02.12.2014
(51) Int. Cl.: H05K 7/20

(54) **EQUIPEMENT ELECTRONIQUE A DOUBLE REFROIDISSEMENT**
ELEKTRONISCHE VORRICHTUNG MIT DOPPELTER KÜHLUNG
ELECTRONIC EQUIPMENT WITH DOUBLE COOLING

(30) Priorité: 13.12.2013 FR 1362599
(43) Date de publication de la demande: 19.10.2016
(73) Titulaire: SAGEMCOM BROADBAND SAS, 92500 Rueil Malmaison (FR)
(72) Inventeur: DANGY-CAYE, Nicolas, F-92500 Rueil Malmaison (FR)
(74) Mandataire: Lavialle, Bruno François Stéphane
(86) Numéro de dépôt international: PCT/EP2014/076320
(87) Numéro de publication internationale: WO 2015/086385

(56) Documents cités:
- EP-A1- 2 138 922
- EP-A2- 2 603 068
- WO-A2-2009/057124
- US-A1- 2003 156 385

## Description

La présente invention concerne un équipement électronique domestique ou professionnel comme, par exemple, une passerelle Internet, un équipement multimédia ou autre.

Un tel équipement comprend généralement un boîtier renfermant des composants électroniques destinés à être raccordés à une source de tension électrique. En cours de fonctionnement, la plupart des composants électriques s'échauffent et il est nécessaire de prévoir des moyens de refroidissement permettant d'empêcher que la température dans le boîtier s'élève au point de devenir incompatible avec le fonctionnement correct de l'équipement.

Pour des équipements dont les composants électroniques s'échauffent peu ou résistent à la température, il est prévu dans le boîtier des ouvertures inférieures et supérieures permettant, au sein du boîtier, la formation par convection d'un flux d'air circulant naturellement entre les ouvertures inférieures et supérieures. La ventilation naturelle est intéressante par son silence mais pâtit d'une capacité de refroidissement limitée. La chaleur Q qui peut être dissipée est égale à h x S x ΔT où h est le coefficient d'échange convectif, S est la surface du produit et ΔT est la différence de température entre la surface et l'air ambiant. Pour augmenter la capacité de refroidissement, il faut donc soit augmenter le coefficient d'échange convectif, c'est-à-dire augmenter le nombre ou la taille des ouvertures, ou augmenter la surface en contact avec l'air ambiant. Ceci à un impact sur l'esthétique de l'équipement dont les ouvertures sont plus visibles et l'encombrement plus important, impact qui peut être préjudiciable à l'attrait que l'équipement peut exercer sur les utilisateurs potentiels de l'équipement. Le coefficient d'échange convectif et la surface de l'équipement devront être optimisés, du point de vue de la chaleur à dissiper, dans le cas le plus défavorable (c'est-à-dire celui où l'équipement se trouve dans un environnement chaud et engendre un maximum de chaleur) alors que ce cas n'intervient en pratique qu'une faible partie du temps.

Pour les équipements dont les besoins en refroidissement sont plus importants, il est prévu dans le boîtier des ouvertures inférieures et une turbine de ventilation forcée ayant une entrée en communication avec l'intérieur du boîtier et une sortie débouchant à l'extérieur du boîtier pour engendrer, lorsque la turbine est en fonctionnement, un flux de ventilation forcée depuis les ouvertures inférieures jusqu'à la turbine. La ventilation forcée est intéressante par son efficacité et la vitesse de la turbine peut être régulée en fonction des besoins de refroidissement. En revanche le fonctionnement de la turbine est bruyant et oblige à prévoir des moyens d'insonorisation. En outre, pour que la turbine donne toute son efficacité, il est nécessaire de prévoir des conduits étanches entre les ouvertures inférieures et l'entrée de la turbine.

Le document EP-A-2 603 068 décrit un boîtier dans lequel sont définies deux chambres isolées l'une de l'autre : l'une est refroidie par convection naturelle alors que l'autre est équipée d'une turbine pour assurer un refroidissement par convection forcée.

Le document WO-A-2009/057124 décrit un équipement électronique dont le boîtier favorise naturellement un courant convectif vertical par opposition au boîtier classique comportant un ventilateur.

Le document EP-A-2 138 922 décrit un boîtier définissant un volume unique qui peut être parcouru par un flux convectif naturel ou par un flux forcé selon la température régnant dans le boîtier.

Le document US-A-2003/0156385 concerne un boîtier intérieurement cloisonné pour canaliser un flux d'air forcé.

Un but de l'invention est de fournir un équipement à refroidissement amélioré.

A cet effet, on prévoit, selon l'invention, un équipement électronique comprenant un boîtier pourvu d'ouvertures de ventilation et d'une turbine de ventilation forcée ayant une entrée en communication avec l'intérieur du boîtier et une sortie débouchant à l'extérieur du boîtier, caractérisé en ce que le boîtier comprend au moins une cloison interne délimitant au moins une chambre périphérique et une chambre centrale en partie supérieure de laquelle est montée la turbine, au moins une ouverture inférieure interne étant ménagée en partie basse du boîtier dans la chambre centrale, au moins une ouverture inférieure externe étant ménagée en partie basse du boîtier dans la chambre périphérique, au moins une ouverture supérieure interne étant ménagée en partie haute de la cloison et au moins une ouverture supérieure externe étant ménagée en partie haute du boîtier dans la chambre périphérique et/ou dans la chambre centrale, les ouvertures étant agencées pour autoriser un flux de ventilation naturelle depuis les ouvertures inférieures jusqu'à l'ouverture supérieure externe lorsque la turbine est arrêtée et un flux de ventilation forcée depuis les ouvertures inférieures et l'ouverture supérieure externe jusqu'à la turbine lorsque la turbine est en fonctionnement, au moins l'ouverture supérieure externe assurant un passage d'air dans deux sens différents selon le flux de ventilation.

La turbine à l'arrêt empêche une communication directe de la chambre centrale vers l'extérieur pour favoriser le flux de ventilation naturelle dans la chambre périphérique et en fonctionnement assure la création et la sortie du flux de ventilation forcée. Ainsi, les mêmes ouvertures sont utilisées pour le passage du flux de ventilation naturelle et pour le passage du flux de ventilation forcée : l'ouverture inférieure sert toujours d'entrée d'air ; l'ouverture supérieure externe sert de sortie pour le flux de ventilation naturelle et d'entrée pour une partie du flux de ventilation forcée ; l'ouverture supérieure interne assure le passage d'une partie du flux de ventilation forcée de la chambre périphérique vers la chambre centrale. Il est donc possible d'utiliser l'un ou l'autre des modes de ventilation en fonction des besoins de refroidissement.

De préférence, l'ouverture supérieure externe est ménagée en partie haute du boîtier dans la chambre périphérique et l'ouverture supérieure interne assure aussi un passage d'air dans deux sens différents selon le flux de ventilation.

L'ouverture supérieure interne assure alors le passage d'une partie du flux de ventilation naturelle de la chambre centrale vers la chambre périphérique et le passage d'une partie du flux de ventilation forcée de la chambre périphérique vers la chambre centrale.

De préférence encore, au moins une ouverture inférieure externe est ménagée en partie basse du boîtier dans la chambre centrale.

Ceci permet d'augmenter le flux d'air susceptible de circuler dans la chambre centrale en améliorant le balayage de celle-ci par ledit flux d'air.

D'autres caractéristiques et avantages de l'invention ressortiront à la lecture de la description qui suit de modes de réalisation particuliers non limitatifs de l'invention.

Il sera fait référence aux dessins annexés, parmi lesquels :
- la figure 1 est une vue schématique en coupe et de dessus d'un équipement conforme à l'invention ;
- la figure 2 est une vue schématique de cet équipement en coupe selon la ligne II-II de la figure 1, en mode de ventilation forcée ;
- la figure 3 est une vue analogue à la figure 2 de l'équipement en mode de ventilation naturelle ;
- la figure 4a est une vue schématique en perspective d'une cloison séparant la chambre centrale et une des chambres périphériques ;
- la figure 4b est une vue schématique en perspective d'une cloison séparant la chambre centrale et une autre des chambres périphériques ;
- la figure 5 est une vue analogue à la figure 2 d'un équipement conforme à une première variante de réalisation de l'invention ;
- la figure 6 est une vue analogue à la figure 2 d'équipement conforme à une deuxième variante de réalisation de l'invention.

L'invention est ici décrite en application à un équipement électronique tel qu'une passerelle informatique ou un appareil multimédia.

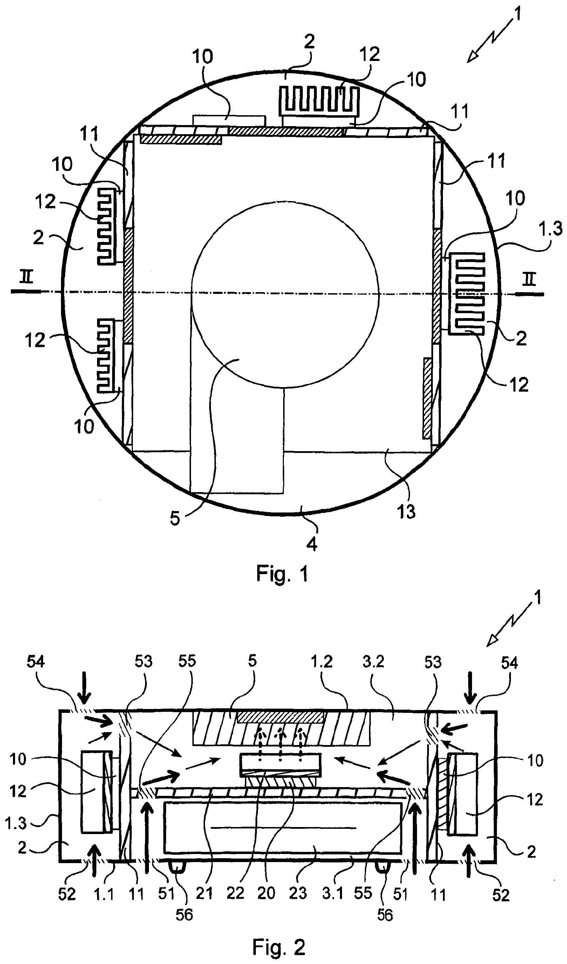

En référence aux figures 1 à 4, l'équipement électronique comprend un boîtier, généralement désigné en 1, comportant une paroi inférieure 1.1, une paroi supérieure 1.2 et une paroi périphérique 1.3 s'étendant entre les parois inférieure 1.1 et supérieure 1.2 pour délimiter une enceinte.

Ladite enceinte reçoit des composants électroniques, notamment des composants électroniques 10 portés par trois plaques de circuit imprimé 11 s'étendant verticalement entre les parois inférieure 1.1 et supérieure 1.2 pour former des cloisons délimitant dans l'enceinte trois chambres périphériques 2 entourant une chambre centrale 3 de forme sensiblement carrée. Les composants électroniques 10 s'étendent du côté des plaques de circuit imprimé 11 tourné vers les chambres périphériques 2 et certains des composants 10 sont pourvus ici d'un radiateur 12. Une paroi verticale 13 s'étend verticalement entre les parois inférieure 1.1 et supérieure 1.2 pour former une cloison délimitant dans l'enceinte une chambre périphérique 4 fermant le quatrième côté de la chambre centrale 3. Les composants électronique 10 sont de préférence des composants fréquemment en fonctionnement comme : des composants d'alimentation qui sont tout le temps en fonctionnement pour alimenter l'équipement, des composant de communication sans fil (de type WIFI par exemple) qui assurent la majeure partie du temps (c'est-à-dire hors opération de téléchargement) un échange minimal de données... Ces composants sont compatibles avec un refroidissement par ventilation naturelle la majeure partie de leur temps de fonctionnement.

La chambre centrale 3 reçoit une turbine 5 de ventilation forcée qui est fixée sous la paroi supérieure 1.2 pour avoir une entrée en communication avec l'intérieur de la chambre centrale 3 et une sortie débouchant à l'extérieur du boîtier 1. La turbine 5 est reliée à une unité de commande connue en elle-même et agencée pour réguler le fonctionnement de la turbine 5 en fonction de températures détectées dans le boîtier 1. L'entrée de la turbine 5 débouche sensiblement sur l'axe vertical central de la chambre centrale 3 et la sortie de la turbine 5 débouche au voisinage de la chambre périphérique 4. La chambre centrale 3 reçoit également au moins un composant électronique 20 solidaire d'une plaque de circuit imprimé 21 fixée dans la chambre centrale 3 pour s'étendre horizontalement et diviser la chambre centrale 3 en un compartiment inférieur 3.1 et un compartiment supérieur 3.2. Le composant électronique 20 est pourvu d'un radiateur 22 et est disposé dans le compartiment supérieur 3.2 au voisinage de l'entrée de la turbine 5. Un dispositif de mémorisation 23, tel qu'un disque dur, est monté dans le compartiment inférieur 3.1.

On notera que le nombre et le type de composants électroniques, de même que le circuit électrique les reliant, importent peu eu égard à l'invention.

L'équipement est pourvu d'ouvertures de ventilation, à savoir :
- au moins une ouverture inférieure externe 51 ménagée en partie basse du boîtier 1 dans la chambre centrale 3 (de préférence plusieurs ouvertures inférieures externes 51 sont ici ménagée en partie basse du boîtier 1 et sont réparties sur le pourtour de la chambre centrale),
- au moins une ouverture inférieure externe 52 ménagée en partie basse du boîtier 1 dans chaque chambre périphérique 2,
- au moins une ouverture supérieure interne 53 délimitée en partie haute de chaque plaque de circuit imprimé 11,
- au moins une ouverture supérieure externe 54 ménagée en partie haute du boîtier 1 dans chaque chambre périphérique 2,
- des ouvertures intermédiaires internes 55 délimitées dans la plaque de circuit imprimé 21.

Les ouvertures inférieures externes 51 sont ménagées dans la paroi inférieure 1.1 et débouchent ainsi sur une surface inférieure du boîtier 1.

Les ouvertures inférieures externes 52 sont ménagées dans la paroi inférieure 1.1 et débouchent ainsi sur la surface inférieure du boîtier 1.

On notera que le boîtier comprend des pieds 56 sur lequel repose le boîtier 1 de telle manière que les ouvertures inférieures externes 51, 52 restent dégagées.

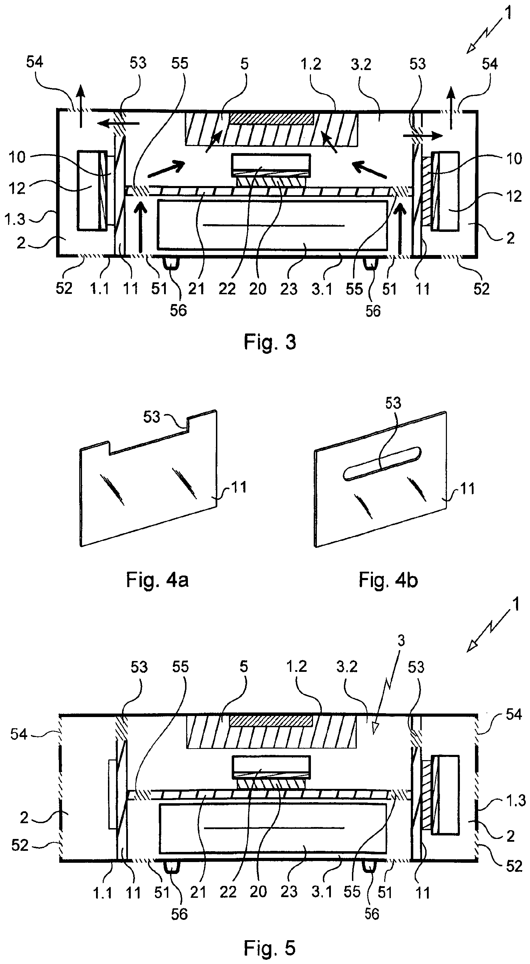

Sur les figures 2 et 3, on peut voir qu'à droite l'ouverture supérieure interne 53 a été découpée directement dans la plaque de circuit imprimé 11 (figure 4b) et qu'à gauche l'ouverture supérieure interne 53 comprend une encoche ménagée dans le bord supérieur de la plaque de circuit imprimé 11 de sorte que l'ouverture supérieure interne 53 est délimitée entre la plaque de circuit imprimé 11 et la paroi supérieure 1.2 du boîtier 1 (figure 4b).

Les ouvertures supérieures externes 54 sont ménagées dans la paroi supérieure 1.2 et débouchent sur une surface supérieure du boîtier 1.

Les ouvertures intermédiaires internes 55 sont découpées directement dans la plaque de circuit imprimé 21 ou sont délimitées par la plaque de circuit imprimé 11 et le bord d'une encoche ménagée dans la plaque de circuit imprimé 21.

Le principe de refroidissement de l'équipement en cours de fonctionnement va désormais être décrit.

Les ouvertures sont ainsi agencées pour autoriser un flux de ventilation naturelle depuis les ouvertures inférieures jusqu'à l'ouverture supérieure externe lorsque la turbine est arrêtée et un flux de ventilation forcée depuis les ouvertures inférieures et l'ouverture supérieure externe jusqu'à la turbine lorsque la turbine est en fonctionnement. La turbine 5 à l'arrêt empêche une communication directe de la chambre centrale 3 vers l'extérieur pour favoriser le flux de ventilation naturelle dans la chambre périphérique 2 et en fonctionnement assure la création et la sortie du flux de ventilation forcée.

Plus précisément, lorsque la turbine 5 est arrêtée, l'échauffement des composants électroniques engendre un phénomène de convection qui produit :
- un premier flux de ventilation naturelle dans chaque chambre périphérique 2, ce flux entrant dans le boîtier 1 par les ouvertures inférieures externes 52 pour en sortir par les ouvertures supérieures externes 54 ;
- un deuxième flux de ventilation naturelle dans le boîtier 1, ce flux entrant dans la chambre centrale 3 par les ouvertures inférieures internes 51, passant par les ouvertures intermédiaires internes 55 puis sortant de la chambre centrale 3 par les ouvertures supérieures internes 53 pour rejoindre le premier flux de ventilation naturelle et sortir par les ouvertures supérieures externes 54.

Lorsque la turbine 5 est en fonctionnement, elle crée le flux de ventilation forcée qui comprend :
- un premier flux de ventilation forcée dans la chambre centrale 3, ce flux entrant dans la chambre centrale 3 par les ouvertures inférieures internes 51, passant par les ouvertures intermédiaires internes 55 puis sortant de la chambre centrale 3 par la turbine 5 ;
- un deuxième flux de ventilation forcée dans chaque chambre périphérique 2, ce flux entrant dans les chambres périphériques 2 par les ouvertures inférieures externes 52, rentrant dans la chambre centrale 3 par les ouvertures supérieures internes 53 puis sortant de la chambre centrale 3 par la turbine 5 ;
- un troisième flux de ventilation forcée dans chaque chambre périphérique 2, ce flux entrant dans les chambres périphériques 2 par les ouvertures supérieures externes 54, rentrant dans la chambre centrale 3 par les ouvertures supérieures internes 53 puis sortant de la chambre centrale 3 par la turbine 5.

On constate que les ouvertures supérieures 53, 54 assurent un passage d'air dans deux sens différents selon que la ventilation est naturelle ou forcée.

Les ouvertures d'au moins une des chambres périphériques peuvent avoir des aires différentes de celles des ouvertures d'au moins une autre des chambres périphériques lorsque ces chambres périphériques contiennent des composants électroniques ayant des besoins de refroidissement différents.

On notera que les composants électroniques 10, 20 et leur radiateur 12, 22 sont positionnés pour s'étendre dans les flux de ventilation.

Selon une première variante et en référence à la figure 5 :
- les ouvertures inférieures externes 52 sont ménagées dans la partie inférieure de la paroi latérale 1.3 et débouchent ainsi sur une surface latérale du boîtier 1 ;
- les ouvertures supérieures externes 54 sont ménagées dans la partie supérieure de la paroi latérale 1.3 et débouchent ainsi sur une surface latérale du boîtier 1 ;
- le boîtier 1 est pourvue d'ouvertures intermédiaires externes qui sont ménagées dans une partie intermédiaire (en hauteur) de la paroi latérale 1.3 et débouchent ainsi sur une surface latérale du boîtier 1.

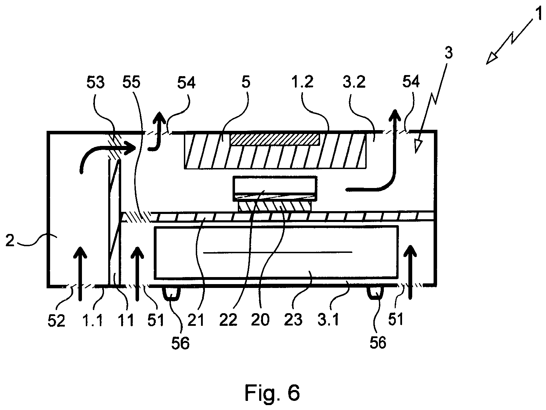

Selon une deuxième variante et en référence à la figure 6 :
- le boîtier 1 ne comprend ici qu'une chambre périphérique 2 et une chambre centrale 3 (ou plus précisément principale) ;
- des ouvertures inférieures externes 51 sont ménagées dans la partie inférieure de la paroi inférieure 1.1 pour déboucher dans la chambre principale 3 ;
- une ouverture inférieure externe 52 est ménagée dans la partie inférieure de la paroi inférieure 1.1 pour déboucher dans la chambre périphérique 2 ;
- une ouverture supérieure interne 53 est délimitée en partie haute de la plaque de circuit imprimé 11 séparant la chambre périphérique 2 de la chambre principale 3 ;
- au moins une ouverture supérieure externe 54 est ménagée dans la paroi supérieure 1.2 pour déboucher dans la chambre principale 3 entre la plaque de circuit imprimé 11 et la turbine 5 (ici plusieurs ouvertures supérieures externes 54 sont ménagées dans la paroi supérieure 1.2 pour déboucher sur le pourtour de la chambre principale 3) ;
- des ouvertures intermédiaires internes 55 sont délimitées dans la plaque de circuit imprimé 21.

Lorsque la turbine 5 est arrêtée, l'échauffement des composants électroniques engendre un phénomène de convection qui produit :
- un premier flux de ventilation naturelle dans chaque chambre périphérique 2, ce flux entrant dans le boîtier 1 par l'ouverture inférieure externe 52, sortant de la chambre périphérique par l'ouverture supérieure interne 53 pour s'échapper par les ouvertures supérieures externes 54 ;
- un deuxième flux de ventilation naturelle dans le boîtier 1, ce flux entrant dans la chambre principale 3 par les ouvertures inférieures externes 51, passant par les ouvertures intermédiaires internes 55 puis sortant de la chambre principale 3 par les ouvertures supérieures externes 54.

Lorsque la turbine 5 est en fonctionnement, elle crée le flux de ventilation forcée qui comprend :
- un premier flux de ventilation forcée dans la chambre principale 3, ce flux entrant dans la chambre principale 3 par les ouvertures inférieures externes 51, passant par les ouvertures intermédiaires internes 55 puis sortant de la chambre centrale 3 par la turbine 5 ;
- un deuxième flux de ventilation forcée dans la chambre périphérique 2, ce flux entrant dans la chambre périphérique 2 par l'ouverture inférieure externe 52, rentrant dans la chambre principale 3 par l'ouverture supérieure interne 53 puis sortant de la chambre centrale 3 par la turbine 5 ;
- un troisième flux de ventilation forcée dans la chambre principale 3, ce flux entrant dans la chambre principale 3 par les ouvertures supérieures externes 54 puis sortant de la chambre principale 3 par la turbine 5.

On constate que les ouvertures supérieures 54 assurent un passage d'air dans deux sens différents selon que la ventilation est naturelle ou forcée.

Bien entendu, l'invention n'est pas limitée aux modes de réalisation décrits mais englobe toute variante entrant dans le champ de l'invention telle que définie par les revendications.

En particulier, le type d'équipement peut être différent de celui décrit, l'invention s'appliquant au refroidissement de tout équipement électronique quel qu'il soit.

L'équipement peut comprendre un nombre différent de chambres périphériques dans le boîtier, et par exemple une seule chambre périphérique.

## Revendications

1. Equipement électronique comprenant un boîtier (1) pourvu d'ouvertures de ventilation et d'une turbine (5) de ventilation forcée ayant une entrée en communication avec l'intérieur du boîtier et une sortie débouchant à l'extérieur du boîtier, et des moyens de commande de la turbine, **caractérisé en ce que** :
- le boîtier comprend au moins une cloison interne délimitant au moins une chambre périphérique (2) et une chambre centrale (3) en partie supérieure de laquelle est montée la turbine,
- au moins une ouverture inférieure externe (51) est ménagée en partie basse du boîtier dans la chambre centrale,
- au moins une ouverture inférieure externe (52) est ménagée en partie basse du boîtier dans la chambre périphérique,
- au moins une ouverture supérieure interne (53) est délimitée en partie haute de la cloison,
- au moins une ouverture supérieure externe (54) est ménagée en partie haute du boîtier dans la chambre périphérique et/ou dans la chambre centrale,
- les ouvertures sont agencées pour autoriser un flux de ventilation naturelle depuis les ouvertures inférieures jusqu'à l'ouverture supérieure externe lorsque la turbine est arrêtée et un flux de ventilation forcée depuis les ouvertures inférieures et l'ouverture supérieure externe jusqu'à la turbine lorsque la turbine est en fonctionnement, au moins l'ouverture supérieure externe assurant un passage d'air dans deux sens différents selon le flux de ventilation.

2. Equipement selon la revendication 1, dans lequel l'ouverture supérieure externe (54) est ménagée en partie haute du boîtier dans la chambre périphérique (2) et l'ouverture supérieure interne (53) assure aussi un passage d'air dans deux sens différents selon le flux de ventilation.

3. Equipement selon la revendication 1 ou 2, dans lequel au moins une ouverture inférieure externe (51) est ménagée en partie basse du boîtier (1) dans la chambre centrale (3).

4. Equipement selon l'une des revendications 1 à 3, dans lequel au moins un composant électronique (10) est monté sur la cloison dans la chambre périphérique (2) .

5. Equipement selon la revendication 4, dans lequel un radiateur (12) est fixé sur le composant (10) pour s'étendre dans les flux de ventilation.

6. Equipement selon la revendication 1, dans lequel la chambre centrale (2) reçoit une plaque de circuit imprimé (21) s'étendant horizontalement et divisant la chambre centrale en un compartiment inférieur et un compartiment supérieur, la plaque de circuit imprimé délimitant au moins une ouverture intermédiaire interne (55) de passage d'air du compartiment inférieur vers le compartiment supérieur.

7. Equipement selon la revendication 6, dans lequel un composant électronique (20) à refroidir est monté sur la plaque de circuit imprimé dans le compartiment supérieur au voisinage de l'entrée de la turbine.

8. Equipement selon la revendication 1, dans lequel l'ouverture inférieure externe (51, 52) débouche sur une surface inférieure du boîtier (1).

9. Equipement selon la revendication 1, dans lequel l'ouverture inférieure externe (52) débouche sur une surface latérale du boîtier (1).

10. Equipement selon la revendication 1, dans lequel l'ouverture supérieure externe (54) débouche sur une surface supérieure du boîtier (1).

11. Equipement selon la revendication 1, dans lequel l'ouverture supérieure externe (54) débouche sur une surface latérale du boîtier (1).

12. Equipement selon la revendication 1, dans laquelle l'ouverture supérieure interne (53) est ménagée dans la cloison.

13. Equipement selon la revendication 1, dans laquelle l'ouverture supérieure interne (53) est délimitée entre la cloison et une paroi supérieure (1.2) du boîtier (1).

14. Equipement selon la revendication 1, dans lequel le boîtier (1) est pourvu d'au moins une ouverture intermédiaire externe qui débouche sur une surface latérale du boîtier.

15. Equipement selon la revendication 1, dans lequel plusieurs chambres périphériques (2) sont délimitées dans le boîtier (1).

16. Equipement selon la revendication 15, dans lequel les ouvertures (52, 54) d'au moins une des chambres périphériques (3) ont des aires différentes de celles des ouvertures d'au moins une autre des chambres périphériques.

17. Equipement selon la revendication 1, dans lequel la cloison interne est formée par une plaque de circuit imprimé (11).

## Patentansprüche

1. Elektronische Ausrüstung, umfassend ein Gehäuse (1), das mit Belüftungsöffnungen und einer Zwangsbelüftungsturbine (5) versehen ist, die einen Einlass in Verbindung mit dem Inneren des Gehäuses und einen Auslass hat, der an der Außenseite des Gehäuses mündet, sowie Mittel zur Steuerung der Turbine, **dadurch gekennzeichnet, dass**:
- das Gehäuse mindestens eine innere Trennwand umfasst, die mindestens eine Umfangskammer (2) und eine zentrale Kammer (3) begrenzt, in deren oberem Teil die Turbine angebracht ist,
- mindestens eine äußere untere Öffnung (51) im unteren Teil des Gehäuses in der zentralen Kammer ausgebildet ist,
- mindestens eine äußere untere Öffnung (52) im unteren Teil des Gehäuses in der Umfangskammer ausgebildet ist,
- mindestens eine innere obere Öffnung (53) im oberen Teil der Trennwand begrenzt ist,
- mindestens eine äußere obere Öffnung (54) im oberen Teil des Gehäuses in der Umfangskammer und/oder in der zentralen Kammer ausgebildet ist,
- die Öffnungen ausgebildet sind, um einen natürlichen Belüftungsstrom von den unteren Öffnungen bis zur äußeren oberen Öffnung zu gestatten, wenn die Turbine angehalten wird, und einen Zwangsbelüftungsstrom von den unteren Öffnungen und der äußeren oberen Öffnung bis zur Turbine zu gestatten, wenn die Turbine in Betrieb ist, wobei mindestens die äußere obere Öffnung einen Luftdurchtritt in zwei verschiedene Richtungen abhängig von dem Belüftungsstrom sicherstellt.

2. Ausrüstung nach Anspruch 1, bei der die äußere obere Öffnung (54) im oberen Teil des Gehäuses in der Umfangskammer (2) ausgebildet ist und die innere obere Öffnung (53) auch einen Luftdurchtritt in zwei verschiedene Richtungen abhängig von dem Belüftungsstrom sicherstellt.

3. Ausrüstung nach Anspruch 1 oder 2, bei der mindestens eine äußere untere Öffnung (51) im unteren Teil des Gehäuses (1) in der zentralen Kammer (3) ausgebildet ist.

4. Ausrüstung nach einem der Ansprüche 1 bis 3, bei der mindestens ein elektronisches Bauelement (10) an der Trennwand in der Umfangskammer (2) angebracht ist.

5. Ausrüstung nach Anspruch 4, bei der ein Kühler (12) an dem Bauelement (10) befestigt ist, um sich in den Belüftungsströmen zu erstrecken.

6. Ausrüstung nach Anspruch 1, bei der die zentrale Kammer (2) eine Leiterplatte (21) aufnimmt, die sich horizontal erstreckt und die zentrale Kammer in einen unteren Raum und einen oberen Raum unterteilt, wobei die Leiterplatte mindestens eine innere Zwischenöffnung (55) zum Luftdurchtritt vom unteren Raum zum oberen Raum begrenzt.

7. Ausrüstung nach Anspruch 6, bei der ein zu kühlendes elektronisches Bauelement (20) auf der Leiterplatte in dem oberen Raum nahe dem Einlass der Turbine angebracht ist.

8. Ausrüstung nach Anspruch 1, bei der die äußere untere Öffnung (51, 52) auf einer unteren Fläche des Gehäuses (1) mündet.

9. Ausrüstung nach Anspruch 1, bei der die äußere untere Öffnung (52) auf einer Seitenfläche des Gehäuses (1) mündet.

10. Ausrüstung nach Anspruch 1, bei der die äußere obere Öffnung (54) auf einer oberen Fläche des Gehäuses (1) mündet.

11. Ausrüstung nach Anspruch 1, bei der die äußere obere Öffnung (54) auf einer Seitenfläche des Gehäuses (1) mündet.

12. Ausrüstung nach Anspruch 1, bei der die innere obere Öffnung (53) in der Trennwand ausgebildet ist.

13. Ausrüstung nach Anspruch 1, bei der die innere obere Öffnung (53) zwischen der Trennwand und einer oberen Wand (1.2) des Gehäuses (1) begrenzt ist.

14. Ausrüstung nach Anspruch 1, bei der das Gehäuse (1) mit mindestens einer äußeren Zwischenöffnung versehen ist, die auf einer Seitenfläche des Gehäuses mündet.

15. Ausrüstung nach Anspruch 1, bei der mehrere Umfangskammern (2) in dem Gehäuse (1) begrenzt sind.

16. Ausrüstung nach Anspruch 15, bei der die Öffnungen (52, 54) mindestens einer der Umfangskammern (3) Flächen haben, die sich von denjenigen der Öffnungen mindestens einer anderen Umfangskammer unterscheiden.

17. Ausrüstung nach Anspruch 1, bei der die innere Trennwand von einer Leiterplatte (11) gebildet ist.

## Claims

1. Electronic equipment comprising a box (1) provided with ventilation openings and a forced ventilation blower (5) having an inlet in communication with the inside of the box and an outlet opening to the outside of the box, and means for controlling the blower, the equipment being **characterized in that**:
• the box has at least one internal partition defining at least one peripheral chamber (2) and a central chamber (3) having the blower mounted in its top portion;
• at least one external bottom opening (51) is provided in the bottom portion of the box in the central chamber;
• at least one external bottom opening (52) is provided in the bottom portion of the box in the peripheral chamber;
• at least one internal top opening (53) is defined in the top portion of the partition; and
• at least one external top opening (54) is arranged in the top portion of the box in the peripheral chamber and/or in the central chamber;
• the openings are arranged to allow a natural ventilation stream from the bottom openings to the external top opening when the blower is stopped, and a forced ventilation stream from the bottom openings and the external top opening to the blower when the blower is in operation, at least one external top opening passing air in two different directions depending on the ventilation stream.

2. Equipment according to claim 1, wherein the external top opening (54) is provided in the top portion of the box in the peripheral chamber (2) and the internal top opening (53) also passes air in two different directions depending on the ventilation stream.

3. Equipment according to claim 1 or claim 2, wherein at least one external bottom opening (51) is arranged in the bottom portion of the box (1) in the central chamber (3).

4. Equipment according to any one of claims 1 to 3, wherein at least one electronic component (10) is mounted on the partition in the peripheral chamber (2).

5. Equipment according to claim 4, wherein a radiator (12) is fastened on the component (10) in order to extend into the ventilation streams.

6. Equipment according to claim 1, wherein the central chamber (2) receives a printed circuit plate (21) extending horizontally and dividing the central chamber into a bottom compartment and a top compartment, the printed circuit plate defining at least one internal intermediate opening (55) for passing air from the bottom compartment to the top compartment.

7. Equipment according to claim 6, wherein an electronic component (20) for cooling is mounted on the printed circuit plate in the top compartment in the vicinity of the inlet of the blower.

8. Equipment according to claim 1, wherein the external bottom opening (51, 52) opens out in a bottom surface of the box (1).

9. Equipment according to claim 1, wherein the external bottom opening (52) opens out in a side surface of the box (1).

10. Equipment according to claim 1, wherein the external top opening (54) opens out in a top surface of the box (1) .

11. Equipment according to claim 1, wherein the external top opening (54) opens out in a side surface of the box (1) .

12. Equipment according to claim 1, wherein the internal top opening (53) is arranged in the partition.

13. Equipment according to claim 1, wherein the internal top opening (53) is defined between the partition and a top wall (1.2) of the box (1).

14. Equipment according to claim 1, wherein the box (1) has at least one external intermediate opening that opens out in a side surface of the box.

15. Equipment according to claim 1, wherein a plurality of peripheral chambers (2) are defined in the box (1).

16. Equipment according to claim 15, wherein the openings (52, 54) of at least one of the peripheral chambers (3) present areas that are different from the areas of the openings of at least one other peripheral chamber.

17. Equipment according to claim 1, wherein the internal partition is formed by a printed circuit plate (11).
